(19) Europäisches Patentamt
European Patent Office
Office européen des brevets

(11) **EP 3 748 379 A1**

(12) **EUROPÄISCHE PATENTANMELDUNG**

(43) Veröffentlichungstag:
**09.12.2020   Patentblatt 2020/50**

(51) Int Cl.:
*G01R 31/327* (2006.01)   *H01H 1/00* (2006.01)

(21) Anmeldenummer: **19178489.1**

(22) Anmeldetag: **05.06.2019**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Siemens Aktiengesellschaft**
**80333 München (DE)**

(72) Erfinder:
• **Mladenovic, Ivana**
**90556 Seukendorf (DE)**
• **Nikolic, Paul Gregor**
**53881 Euskirchen (DE)**

(54) **VERFAHREN ZUR ÜBERPRÜFUNG EINES BEREITSCHAFTSZUSTANDES EINER UNTERBRECHEREINHEIT**

(57)     Die Erfindung betrifft ein Verfahren zur Überprüfung eines Bereitschaftszustandes einer Unterbrechereinheit (2), umfassend folgende Schritte:
- Messung einer Stromstärke (I) während eines Schaltvorganges (4),
- Bestimmung der den Schaltvorgang (4) begrenzenden Zeitpunkten ($t_1$, $t_3$)
- Ermittlung einer während des Schaltvorgangs (4) in die Unterbrechereinheit (2) eingebrachten Energiemenge (E) aus der dabei geflossenen Strommenge,
- Ermittlung einer charakteristischen Kontaktgeometrie in Abhängigkeit der eingebrachten Energiemenge (E),
- Bereitstellen einer Tabelle (6), die Werte der eingebrachten Energiemenge (E) Werte der charakteristischen Kontaktgeometrie zuordnet.

FIG 1

**Beschreibung**

Für einen sicheren Netzbetrieb von Hoch- oder Mittelspannungsnetzen spielt der Zustand der Betriebsmittel, die im Netz eingesetzt werden, eine entscheidende Rolle. Daher müssen in unterschiedlichen Abständen bevorzugt in regelmäßigen Zeitintervallen die Betriebsmittel geprüft und erneuert werden. Eine wirtschaftliche Erneuerung und Instandhaltungsplanung setzt ein Wissen über den Zustand der Betriebsmittel voraus, weshalb eine technische Überprüfung des Zustandes der Betriebsmittel einen wesentlichen Beitrag über die Wirtschaftlichkeit des Netzbetriebes im Allgemeinen liefert.

Insbesondere Hoch- oder Mittelspannungsschaltgeräte und dort insbesondere das Kontaktsystem, das beim Auftreten eines Schaltlichtbogens einen erheblichen Materialabbrandt erlebt, ist ein komplexes System, dessen Funktionsfähigkeit nur sehr aufwändig geprüft werden kann. Dies erfolgt derzeit durch mechanisches Zerlegen, einer mechanischen Prüfung und einer anschließenden Remontage. Gerade bei der Remontage von Schaltgeräten und deren Antriebssystemen wurde eine hohe Fehleranfälligkeit festgestellt. So ist die Lebensdauer nach durchgeführter Wartung häufig niedriger ist als vor der Wartung.

Die Aufgabe der Erfindung besteht darin, ein Verfahren zur Zustandsbestimmung eines Kontaktsystems für ein Hoch- oder Mittelspannungsschaltgerät bereitzustellen, das dazu geeignet ist, eine technische Zustandsbestimmung zu generieren und dabei die Notwendigkeit des mechanischen bzw. manuellen Eingriffs in das Schaltgerät möglichst zu vermeiden oder zu reduzieren.

Die Lösung der Aufgabe besteht in einem Verfahren zur Überprüfung eines Bereitschaftszustands einer Unterbrechereinheit mit den Merkmalen des Patentanspruchs 1. Dieses Verfahren umfasst dabei folgende Schritte:
Messung einer Stromstärke während eines Schaltvorganges, Bestimmung der den Schaltvorgang begrenzenden Zeitpunkten, Ermittlung einer während des Schaltvorgangs in die Unterbrechereinheit eingebrachten Energiemenge aus der dabei geflossenen Strommenge. Ferner erfolgt im Weiteren eine Ermittlung einer charakteristischen Kontaktgeometrie in Abhängigkeit der eingebrachten Energiemenge. Anschließend erfolgt ein Bereitstellen einer Tabelle, die Werte der eingebrachten Energiemenge Werten der charakteristischen Kontaktgeometrie zuordnet.

Das beschriebene Verfahren dient dazu, anhand der eingebrachten Energiemenge eine charakteristischen Kontaktgeometrie abzuleiten und dies universell für baugleiche Unterbrechereinheiten bereitzustellen, um eine bessere Vorhersage über den Alterungsprozess vergleichbarer Unterbrechereinheiten vorzunehmen. Hierzu wird insbesondere lediglich die tatsächlich in die Unterbrechereinheit eingebrachte Energiemenge gemessen, wobei die Bestimmung der den Schaltvorgang begrenzenden Zeitpunkte zur Eingrenzung der Schaltdauer und somit des zu messenden Stromflusses dient.

In einer weiteren Ausgestaltungsform der Erfindung wird das beschriebene Verfahren durch folgende Schritte ergänzt: Messen der in einer zweiten, im Wesentlichen baugleichen Unterbrechereinheit eingebrachten Energiemenge während eines Betriebsintervalls und die Ermittlung der energiemengenabhängigen Kontaktgeometrie mittels der in der Datenbank bereitgestellten Verhältnisses.

Die einmal bereitgestellte Tabelle, die insbesondere auf Informationen und Know-how des Herstellers der Unterbrechereinheit basieren, kann nun für eine Vielzahl baugleicher Geräte abgerufen werden, was dazu führt, dass die Wartungsintervalle aufgrund der gewonnenen Daten verlängert werden können. Ferner können Voraussagen getroffen werden, wann eine entsprechende Unterbrechereinheit ausgetauscht bzw. generalüberholt werden muss. Auf diese Weise wird vermieden, manuelle Wartungsarbeiten an der Unterbrechereinheit vornehmen zu müssen, was zu einem sicheren Betrieb nach der Wartung führt, da Bedienungsfehler durch menschliche Montageeingriffe vermieden werden können.

In einer weiteren vorteilhaften Ausgestaltungsform der Erfindung wird die Schaltdauer des Schaltvorgangs in einem Zeitintervall zwischen dem Auftreten eines Fehlerstromsignals und dem Zeitpunkt des Erlöschens eines Schaltlichtbogens ermittelt. Durch diesen beschriebenen Vorgang kann die Schaltdauer genau und reproduzierbar festgelegt werden. Da im Wesentlichen nur während diesen beschriebenen Schaltzeitpunkten Energie in die Unterbrechereinheit einfließt, kann die Energie während der Gesamtlebensdauer der Unterbrechereinheit sehr genau ermittelt werden. Insbesondere erfolgt die Ermittlung der eingebrachten Energie über die Integration des geflossenen Stroms über die Schaltdauer.

In einer ebenfalls vorteilhaften Ausgestaltungsform der Erfindung wird die Strommenge des Energieeintrages in die Unterbrechereinheit mit einem zur Unterbrechereinheit korrespondierenden Messwandlers ermittelt.

Weitere Ausgestaltungsformen und weitere Merkmale werden anhand der folgenden Figuren näher erläutert. Dabei handelt es sich um rein schematische Ausgestaltungsformen, die keine Einschränkung des Schutzbereichs darstellen.

Dabei zeigen:

Figur 1    eine schematische Darstellung der Messung der eingebrachten Energie in eine Unterbrechereinheit und den Abgleich mit zwei Unterbrechereinheiten,

Figur 2    der Verlauf eines Strom-Zeitdiagrammes während eines Schaltvorganges.

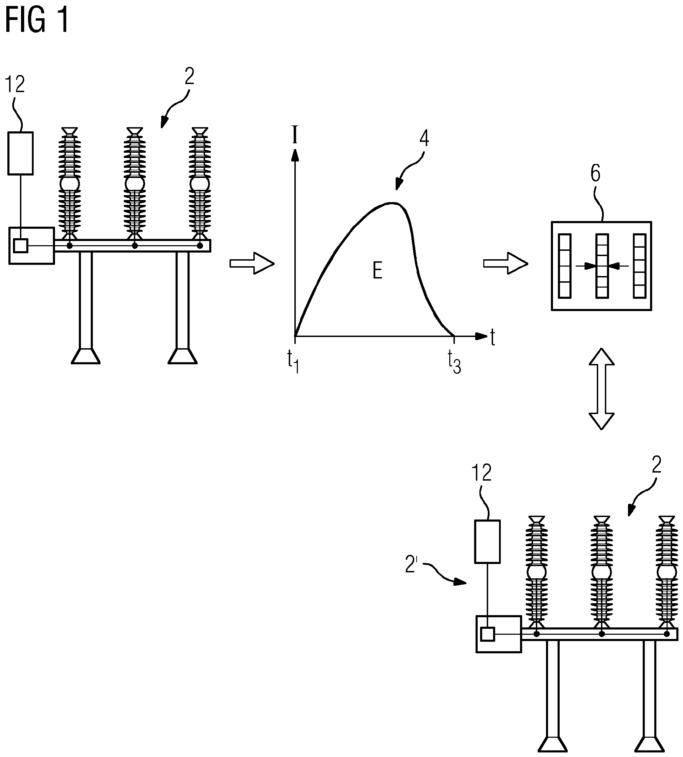

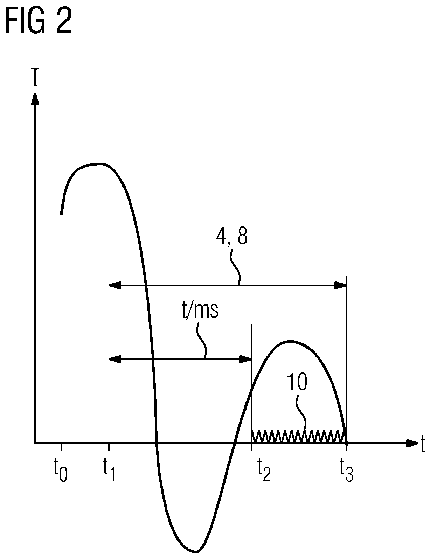

In der Figur 1 ist in schematischer Form ein Verfahren zur Überprüfung eines Betriebszustandes einer Unterbrechereinheit 2 dargestellt. Bei der skizzenhaften Darstellung der Figur 2 handelt es sich um eine dreiphasige Hochspannungsunterbrechereinheit, die eine hier nicht näher dargestellte Antriebseinheit aufweist. Bei jedem Schaltvorgang, insbesondere bei einer Kurzschlussunterbrechung, kommt es aufgrund des auftretenden Schaltlichtbogens zu einer starken Abnutzung der Kontakte und der Bauteile der Unterbrechereinheit. Grundsätzlich kann eine Unterbrechereinheit 2 eine Vielzahl von Schaltvorgängen während ihrer Betriebszeit von ca. 40 Jahren vornehmen, bevor sie ausgetauscht werden muss. Jeder einzelne Schaltvorgang hat jedoch einen unterschiedlichen Energieeintrag, sodass allein durch das Zählen der Schaltvorgänge keine sichere Abschätzung des Zustandes im Inneren der Unterbrechereinheit vorgenommen werden kann. Aus diesem Grund wird üblicherweise gemäß dem Stand der Technik manuell in die Unterbrechereinheit eingegriffen und der Zustand optisch bewertet. Es besteht jedoch die Gefahr, dass beim Wiederzusammenbau der Unterbrechereinheit Montagefehler auftreten, weshalb es sich herausgestellt hat, dass nach einer Wartung die Fehlerwahrscheinlichkeit höher sein kann als vorher. Zusätzlich ermöglicht die Beobachtung der geschalteten Energiemengen, die Zählung der Schaltungen und entsprechende Korrelation zwischen den bekannten Größen (z.B. summierte geschaltete Energie, maximale geschaltete Energiemenge, Anzahl der durchgeführten Schaltungen)eine Abschätzung bzw. Prognose der Restlebensdauer bzw. der noch verbleibenden Schaltervorgängen bei einem vordefinierten Fehlerstrom. Nach jedem Schaltvorgang wird dieser Wert entsprechend aktualisiert.

Aus diesem Grund wird gemäß des Verfahrens gemäß Figur 1 bei jedem Schaltvorgang die Stromstärke I über den Zeitraum des Schaltvorganges ermittelt. Dieser Zeitraum, der auch als Schaltdauer 8 bezeichnet wird, wird schematisch durch die Zeitpunkte $t_1$ und $t_3$ in dem I-t-Diagramm gemäß Figur 1 dargestellt. Die Fläche der in dem I-t-Diagramm dargestellten Kurve entspricht der Energiemenge E, die während des Schaltvorganges in die Unterbrechereinheit 2 eingebracht wird. Die Energiemenge E errechnet sich aus dem Integral über dem Strom zwischen den zwei Endpunkten $t_1$ und $t_3$ und kann ausgeschrieben werden als

$$\mathrm{E} \; = \; \int_{t_2}^{t3} I^2 dt \, .$$

An der Unterbrechereinheit 2 wird anschließend eine Untersuchung der hier nicht dargestellten Kontakte vorgenommen und eine charakteristische Kontaktgeometrie festgehalten. Die charakteristische Kontaktgeometrie kann beispielsweise durch Messung der Länge eines Stiftkontaktes erfolgen, der sich bei jedem Schaltvorgang durch Abbrand leicht verkürzt. Eine andere Möglichkeit, die charakteristische Kontaktgeometrie aufzunehmen, besteht darin, die Oberflächenrauigkeit an definierten Stellen des Kontaktes aufzunehmen. Je nach Art des Kontaktsystems, beispielsweise Vakuumschaltröhre oder gasisolierter Schalter, können hierfür unterschiedliche und zweckmäßige Methoden angewandt werden.

Die definierte und gemessene charakteristische Kontaktgeometrie wird nun in einer Tabelle eingetragen und mit der gemäß des I-t-Diagramms gemessenen eingebrachten Energie verglichen.

Derartige Messungen und die Bereitstellung der entsprechenden Tabelle 6 erfolgt insbesondere im Zugriffsbereich des Hersteller der Unterbrechereinheit 2. Hierfür sind eine Vielzahl von anlagenspezifischer Kenntnisse und Know-how notwendig, um einerseits die Energiemenge E genau zu definieren, die Schaltzeitpunkte $t_1$ und $t_3$ festzulegen und die charakteristische Kontaktgeometrie in Abhängigkeit der eingebrachten Energie zu ermitteln. Die Tabelle 6 kann nun auf einer entsprechenden Datenbank zur Verfügung gestellt werden, sodass bei entsprechender Messung der eingebrachten Energiemenge und einer Vielzahl von Schaltvorgängen einer baugleichen Unterbrechereinheit 2' die Informationen, die in der Tabelle 6 enthalten sind, in analoger Weise auf die Unterbrechereinheit 2' angewandt werden können.

Der Betreiber eines Hoch- oder Mittelspannungsnetzes, der die Unterbrechereinheit 2' in sein Netz integriert hat, kann so über die selbstgewonnenen Energieeintragswerte in Kombination der erstellten Tabelle 6 auf den Zustand seiner Unterbrechereinheit 2' schließen. Neben der Bestimmung einer Verkürzung der Kontakte bzw. der Änderung der Kontaktgeometrie kann auch eine Bestimmung einer kumulativen eingebrachten Energie in Relation zu Anzahl der Schaltungen, die unterbrochen wurden, zweckmäßig sein und im Weiteren für eine langfristige Instandhaltungsplanung verwendet werden.

Die Messwerte, die zur Bestimmung des Energieeintrages E in die Unterbrechereinheit 2 bzw. 2' verwendet werden, werden bevorzugt über mindestens einen Messwandler 12, der mit der Unterbrechereinheit 2 korrespondiert, ermittelt. Durch den Messwandler 12 kann die Stromstärke I während des Schaltvorganges 4 technisch sehr gut ermittelt werden. Eine Spannung, die beim Auftreten eines Schaltlichtbogens 10 (vgl. Figur 2) anliegt, ist durch einen weiteren für Spannungsmessungen vorgesehenen Messwandler nur sehr schlecht ermittelbar, da der Spannungs-Messwandler in einem Spannungsbereich genauere Werte liefert, der weit über dem liegt, in dem sich die Spannungen bei einem Schaltlichtbogen 10 befinden. Somit können keine genauen Spannungswerte ohne größeren technischen Aufwand mit Hilfe des Messwandlers ermittelt werden. Aus diesem Grund ist es zweckmäßig, wie in Figur 2 dargestellt, die Stromstärke I kontinuierlich zu messen und einen ganz bestimmten Schaltdauer 8 zu bestimmen. Dieser Schaltdauer 8 wird in diesem Beispiel durch die Zeitpunkte $t_1$ und $t_3$ nach dem I-t-Diagramm gemäß Figur 2 begrenzt.

Im Weiteren soll auf den Gesamtverlauf des I-t-Diagrammes vor, während und nach eines Schaltvorganges 4 eingegangen werden. Zunächst wäre dann der Zeitpunkt $t_0$ zu erwähnen, der das Ereignis eines Kurzschlusses, beispielsweise auf einer Hochspannungsleitung gefallenen Baumes oder Astes markiert. Vom Eintritt dieses Ereignisses $t_0$ bis zum Eintreffen eines Schaltsignales an der Unterbrechereinheit 2 vergeht eine gewisse Zeit, die im Bereich von wenigen Millisekunden liegt. Der Zeitpunkt $t_1$ beschreibt demnach das Auftreten des Schaltsignales an der Unterbrechereinheit 2. Nun vergeht wiederum eine gewisse Zeit, die ebenfalls im Bereich von Millisekunden liegt, beispielsweise 20 Millisekunden, bis das eintreffende Signal in der Unterbrechereinheit 2 bzw. einer hier nicht dargestellten Steuerung der Unterbrechereinheit 2 verarbeitet wird und ein Öffnungsvorgang des ebenfalls nicht dargestellten Kontaktsystems eingeleitet wird bzw. soweit fortgeschritten ist, bis zwischen den sich voneinander trennenden Kontakten ein Schaltlichtbogen 10 auftritt.

Dieser Zeitpunkt, an dem der Schaltlichtbogen 10 einsetzt, wird im Diagramm gemäß Figur 2 mit $t_2$ bezeichnet. Während dieser Zeit kann die Stromstärke I ein- oder mehrfacher einen Vorzeichenwechsel vorgenommen haben, sodass mehrere Nulldurchgänge der Stromzeitkennlinie erfolgt sind. Der Schaltlichtbogen 10, der grundsätzlich die Hauptbelastung für das Material der Kontakte darstellt, tritt solange auf, bis er durch einen weiteren Nulldurchgang der Stromstärkenkurve beendet wird. Dies kann vom Auftreten des Schaltlichtbogens 10 bis zum Erlöschen mindestens ein Stromnulldurchgang betragen, es könnte jedoch auch ein weiterer Zyklus bis zu einem zweiten oder gar dritten Stromnulldurchgang nötig sein. Dieser Zeitpunkt wird in diesem Diagramm mit $t_3$ bezeichnet. Der Zeitpunkt $t_3$ beschreibt demnach das Erlöschen des Schaltlichtbogens 10. Dies kann festgestellt werden, da dieser Zustand eingetreten ist, wenn der Stromfluss unterbrochen ist.

Für die Schaltdauer 8 gibt es somit im Wesentlichen drei hervorzuhebende Zeitpunkte, zunächst eben das Eintreffen des Schaltsignales ($t_1$), das Einsetzen des Schaltlichtbogens 10 ($t_2$) und das Erlöschen des Schaltlichtbogens ($t_3$). Der Betreiber der Unterbrechereinheit 2' ist in der Lage, die Zeitpunkt $t_1$ und $t_3$ mit den ihm zur Verfügung stehenden technischen Mitteln und Informationen zu ermitteln. Insbesondere das Eintreffen des Signals und das auf null zurückgegangene Stromsignal können mit geringem technischem Aufwand ermittelt werden. Der Betreiber der Unterbrechereinheit 2' ist bei gleichzeitiger Ermittlung des während dieser Zeit geflossenen Stroms I und das Aufintegrierens des geflossenen Stroms I über die Differenzzeit $t_1$ bis $t_3$, in der Lage, mittels einer Datenverarbeitungsvorrichtung die eingebrachte Energie E zu bestimmen. Diese ermittelte Energie E kann der Betreiber über einen entsprechenden Zeitraum (in der Regel mehrere Jahre) in einer eigenen Datenbank speichern und bei einem geplanten Wartungszeitpunkt, der durch entsprechende Wartungsintervalle festgelegt ist, die Summe über die eingebrachte Energie E in die Unterbrechereinheit 2' ermitteln. Neben der eingebrachten Energie ist auch die absolute Anzahl der vorgenommenen Schaltvorgänge und die aufgetretenen Energiespitzen relevante Größen, die zur Zustandsbestimmung mit einfließt.

Anschließend kann der Betreiber der Unterbrechereinheit 2' auf die Tabelle 6 zurückgreifen und aus der durch ihn ermittelten Energie E die zu erwartende Kontaktgeometrie des Kontaktsystems der Unterbrechereinheit 2 feststellen. Dieses Auslesen aus der Datenbank und das Feststellen des Kontaktsystemzustandes kann automatisiert ebenfalls durch eine Datenverarbeitungsvorrichtung erfolgen. Auf dieser Basis kann der Betreiber der Unterbrechereinheit 2' Vorhersagen über die noch zu erwartende Lebensdauer der Unterbrechereinheit 2' treffen und ggf. weitreichende Wartungsarbeiten oder eine Ersatzbeschaffung einleiten.

Bezugszeichenliste

| | |
|---|---|
| 2 | Unterbrechereinheit |
| 4 | Schaltvorgang |
| E | Energiemenge |
| I | Stromstärke |
| 6 | Tabelle |
| 8 | Schaltdauer |
| 10 | Schaltlichtbogen |
| $t_1$ | Fehlerstromsignal |
| $t_2$ | Lichtbogen Beginn |
| $t_3$ | Erlöschen Lichtbogen |
| 12 | Messwandler |

**Patentansprüche**

1. Verfahren zur Überprüfung eines Bereitschaftszustandes einer Unterbrechereinheit (2), umfassend folgende Schritte:

   - Messung einer Stromstärke (I) während eines Schaltvorganges (4),
   - Bestimmung der den Schaltvorgang (4) begrenzenden Zeitpunkten ($t_1$, $t_3$)
   - Ermittlung einer während des Schaltvorgangs (4) in die Unterbrechereinheit (2) eingebrachten Energiemenge (E) aus der dabei geflossenen Strommenge,
   - Ermittlung einer charakteristischen Kontaktgeometrie in Abhängigkeit der eingebrachten Energiemenge (E),
   - Bereitstellen einer Tabelle (6), die Werte der eingebrachten Energiemenge (E) Werte der charakteristischen Kontaktgeometrie zuordnet.

**2.** Verfahren nach Anspruch 1, umfassend folgende Schritte:

> - Messen der in einer zweiten, im Wesentlichen baugleichen Unterbrechereinheit (2') eingebrachten Energiemenge E während eines Betriebsintervalls und
> - Ermittlung der energiemengenabhängigen Kontaktgeometrie mittels der in der Datenbank bereitgestellten Verhältnisses.

**3.** Verfahren nach Anspruch 1 oder 2, **dadurch gekennzeichnet, dass** eine Schaltdauer (8) des Schaltvorgangs (4) in einem Zeitintervall zwischen dem Auftreten eines Fehlerstromsignals ($t_1$) und dem Zeitpunkt ($t_3$) des Erlöschens eines Schaltlicht-bogens (10) ermittelt wird.

**4.** Verfahren nach einem der vorhergehenden Ansprüche, **dadurch gekennzeichnet, dass** die Strommenge an einem mit der Unterbrechereinheit (2) korrespondierenden Messwandler (12) ermittelt wird.

## FIG 1

12

2

I

4

E

t₁ t t₃

6

12

2

2'

FIG 2

Europäisches
Patentamt

European
Patent Office

Office européen
des brevets

# EUROPÄISCHER RECHERCHENBERICHT

Nummer der Anmeldung

EP 19 17 8489

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2001/019573 A1 (DOUGHERTY JOHN J [US] ET AL) 6. September 2001 (2001-09-06) * Abbildungen 1-2 * * Absatz [0019] - Absatz [0040] * ----- | 1,2 | INV. G01R31/327 H01H1/00 |
| X | DE 102 51 656 B3 (SIEMENS AG [DE]) 24. Juni 2004 (2004-06-24) * Absatz [0033] - Absatz [0042] * * Abbildungen 1-5 * ----- | 1,3,4 | |

RECHERCHIERTE SACHGEBIETE (IPC)

G01R
H01H

Der vorliegende Recherchenbericht wurde für alle Patentansprüche erstellt

| Recherchenort | Abschlußdatum der Recherche | Prüfer |
|---|---|---|
| München | 13. November 2019 | Sedlmaier, Stefan |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument

....................................................................................................
& : Mitglied der gleichen Patentfamilie, übereinstimmendes
    Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 19 17 8489

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

13-11-2019

| Im Recherchenbericht angeführtes Patentdokument | Datum der Veröffentlichung | Mitglied(er) der Patentfamilie | Datum der Veröffentlichung |
|---|---|---|---|
| US 2001019573 A1 | 06-09-2001 | DE 10204849 A1<br>US 2001019573 A1 | 22-08-2002<br>06-09-2001 |
| DE 10251656 B3 | 24-06-2004 | CN 1501091 A<br>DE 10251656 B3<br>ES 2255369 A1 | 02-06-2004<br>24-06-2004<br>16-06-2006 |

EPO FORM P0461

Für nähere Einzelheiten zu diesem Anhang : siehe Amtsblatt des Europäischen Patentamts, Nr.12/82